# EUROPÄISCHE PATENTSCHRIFT

(11) **EP 1 495 545 B1**
(45) Veröffentlichungstag und Bekanntmachung des Hinweises auf die Patenterteilung: **20.02.2008**
(21) Anmeldenummer: 03727171.5
(22) Anmeldetag: 02.04.2003
(51) Int. Cl.: H03M 1/10

(54) **VERFAHREN UND VORRICHTUNG ZUR FUNKTIONSPRÜFUNG EINES ANALOG-DIGITAL-WANDLERS SOWIE ANALOG-DIGITAL-WANDLER**
METHOD AND DEVICE FOR FUNCTIONALLY TESTING AN ANALOG-TO-DIGITAL CONVERTER, AND A CORRESPONDING ANALOG-TO-DIGITAL CONVERTER
PROCEDE ET DISPOSITIF DE CONTROLE DU FONCTIONNEMENT D'UN CONVERTISSEUR ANALOGIQUE/NUMERIQUE ET CONVERTISSEUR ANALOGIQUE/NUMERIQUE

(30) Priorität: 08.04.2002 DE 10215405
(43) Veröffentlichungstag der Anmeldung: 12.01.2005
(73) Patentinhaber: ROBERT BOSCH GMBH, 70442 Stuttgart (DE)
(72) Erfinder: HAAG, Wolfgang, 71364 Winnenden (DE); STEINLE, Claus, 70567 Stuttgart (DE); KELLER, Stefan, 71735 Eberdingen (DE)
(86) Internationale Anmeldenummer: PCT/DE2003/001081
(87) Internationale Veröffentlichungsnummer: WO 2003/085834

(56) Entgegenhaltungen:
- EP-A- 0 474 024
- WO-A-01/10031
- WO-A-02/15404
- WO-A-96/31690
- PATENT ABSTRACTS OF JAPAN vol. 014, no. 194 (E-0919), 20. April 1990 (1990-04-20) -& JP 02 041029 A (NEC CORP), 9. Februar 1990 (1990-02-09)

## Beschreibung

### Stand der Technik

Die Erfindung betrifft ein Verfahren und eine Vorrichtung zur Funktionsprüfung eines Analog-Digital-Wandlers sowie einen Analog-Digital-Wandler gemäß den Oberbegriffen der unabhängigen Ansprüchen.

Analog-Digital-Wandler sind in vielfältiger Weise bekannt, wie beispielsweise aus "PC gesteuerte Messtechnik ..." von Klaus Dembowski, Markt- und Technik Verlag 1993.

Ein Verfahren und eine Vorrichtung zur Funktionsprüfung eines Analog-Digital-Wandlers ist daneben aus der DE 195 13 081 A1 bekannt. Dabei wird eine eingestellte Testspannung vom Analog-Digital-Wandler gewandelt. Diese Testspannung wird durch einen Spannungsteiler erzeugt, welcher wie die Referenzspannung des Analog-Digital-Wandler von derselben internen Spannung versorgt wird. Dabei hat der Analog-Digital-Wandler genau eine vorgesehene Referenzspannung, wobei zur Erkennung einer fehlerhaften Referenzspannung der gewandelte Testspannungswert dahingehend geprüft wird, ob er einem bekannten Sollwert innerhalb eines zulässigen Toleranzbandes entspricht.

Die WO-A- 0215404 zeigt einen Analog/Digital-Wandler, der die Verwendung mehrerer Modi erlaubt. In einem ersten Modus wird ein Eingangssignal wahlweise unter Verwendung einer ersten oder zweiten Referenzspannung gewandelt. In einem zweiten Modus wird die Verwendung der zweiten Referenzspannung Vrefverhindert. Außerdem zeigt die Schrift, dass einzelne Referenzspannungen für bestimmte Analog/Digital-Kanäle frei geschaltet werden können.

### Aufgabe der Erfindung

Erfindungsgemäß möchte man nun für verschiedene Signale, beispielsweise in einem Steuergerät, insbesondere in einem Fahrzeug, gewisse Bereiche des Signals oder auch das ganze Signal mit höherer Auflösung wandeln. Dazu soll nicht nur eine feste Referenzspannung für einen Analog-Digital-Wandler eingesetzt werden, sondern mehr als eine Referenzspannung. Erfindungsgemäß werden nun also Analog-Digital-Wandler derart ausgebildet oder konfiguriert, bzw. softwareunterstützt betrieben, dass die Verwendung wenigstens zweier Referenzspannungen für den Analog-Digital-Wandler möglich wird. Damit wird im Steuergerät nicht nur eine feste Referenzspannung, wie im Stand der Technik, sondern es werden wenigstens zwei unterschiedliche Referenzspannungen zur Verfügung gestellt.

Ebenso ist es erfindungsgemäß möglich, insbesondere per Software, jeder beliebigen Analog-Digital-Wandlung auf einem beliebigen Analog-Digital-Kanal eine dieser Referenzspannungen auszuwählen bzw. aufzuschalten. Mit diesen erfindungsgemäß neuen Funktionalitäten sind nun auch Fehlerbilder möglich, die in den bisherigen Rechnergenerationen nicht auftreten konnten, die jedoch im Sinne der Sicherheit beherrscht werden müssen, da eine fehlerhafte interne Referenzspannung bei einem Analog-Digital-Wandler zu einem falschen Wandelergebnis führt, was bei sicherheitskritischen Signalen, wie beispielsweise Signale des Fahrpedalmoduls in einem Fahrzeug erhebliche Folgen, wie beispielsweise im konkreten Beispiel eine fehlerhafte Beschleunigung, nach sich ziehen würden.

Weitere Beispiele und eine weitere Konkretisierung hierzu folgen in der Beschreibung der Ausführungsbeispiele.

Festzuhalten ist, dass mit dem bisherigen Analog-Digital-Wandler Testverfahren, also der bisherigen Funktionsprüfung Fehler, die zu einer ungewollten Umschaltung und damit zu einer falschen Referenzspannung führen, nicht erkannt werden können.

Es ist daher Aufgabe der Erfindung, neben der Ermöglichung der Wandlung eines Signals unter Zuhilfenahme mehrerer Referenzen gleichzeitig die dabei möglichen Fehler sicher zu erkennen und eine entsprechende Fehlerreaktion einzuleiten bzw. auszuführen.

### Vorteile der Erfindung

Die Erfindung geht aus von einem Verfahren und einer Vorrichtung zur Funktionsprüfung eines Analog-Digital-Wandlers ADC, wobei der Analog-Digital-Wandler ADC eine Funktion zur Wandlung wenigstens eines analogen Signals in wenigstens ein digitales Signal unter Verwendung einer ersten vorgegebenen Referenzspannung durchführt, sowie einem entsprechenden Analog-Digital-Wandler.

Vorteilhafter Weise ist der Analog-Digital-Wandler derart ausgestaltet, dass die Funktion des Wandelns alternativ unter Verwendung wenigstens einer weiteren, insbesondere einer vorgegebenen zweiten Referenzspannung durchgeführt werden kann, wobei zur Funktionsprüfung der Analog-Digital-Wandler derart gesperrt wird, dass eine Verwendung wenigstens der weiteren, insbesondere der zweiten Referenzspannung durch den Analog-Digital-Wandler verhindert wird und zweckmäßiger Weise zur Funktionsprüfung ein vorgegebenes analoges Signal in ein digitales Signal gewandelt wird, wobei dieses digitale Signal ausgewertet wird.

Dabei wird vorteilhafter Weise ein analoges Signal unter Verwendung der ersten Referenzspannung gewandelt und zur Funktionsprüfung das unter Verwendung der ersten Referenzspannung gewandelte digitale Signal mit einem unter Verwendung der ersten Referenzspannung erwarteten vorgegebenen Signal ausgewertet (Normalprüfung).

In einer vorteilhaften Ausgestaltung wird das analoge Signal unter Verwendung der ersten Referenzspannung zwar gewandelt, aber zur Funktionsprüfung das unter Verwendung der ersten Referenzspannung gewandelte digitale Signal mit einem unter Verwendung der zweiten Referenzspannung erwarteten vorgegebenen Signal ausgewertet (Kreuzprüfung).

Dabei kann nun vorteilhafter Weise zum einen das aus dem analogen Signal gewandelte digitale Signal mit dem entsprechenden erwarteten Signal verglichen werden oder aus dem digitalen Signal kann die verwendete Referenzspannung ermittelt werden und diese wird dann mit einer erwarteten vorgegebenen Referenzspannung verglichen.

Abhängig von dem Vergleich einerseits der ermittelten Referenzspannung mit der wenigstens einen vorgegebenen Referenzspannung oder auch abhängig von dem Vergleich des aus dem vorgegebenen analogen Signal gewandelten digitalen Signals mit dem wenigstens einen erwarteten Signal kann dann auf Fehler erkannt werden und eine vorgegebene Fehlerreaktion eingeleitet werden.

Dabei kann die Fehlerreaktion zweckmäßiger Weise einmal dann erfolgen, wenn bei dem Vergleich keine Übereinstimmung innerhalb einer vorgebbaren Toleranz erzielt wird oder zum Anderen wenn bei dem Vergleich Übereinstimmung innerhalb einer vorgebbaren Toleranz erzielt wird.

In einer vorteilhaften Ausgestaltung wird das wenigstens eine erste analoge Signal als eine erste Gruppe von ersten Signalen gewandelt und ein wenigstens zweites analoges Signal als eine zweite Gruppe von zweiten Signalen gewandelt, wobei dem ersten Signal nur jeweils genau eine Referenzspannung zur Wandlung zugeordnet ist.

Zweckmäßiger Weise können dann diese beiden Gruppen zwei Analog-Digital-Wandler-Bänken bzw. einem ersten Analog-Digital-Wandler und einem zweiten Analog-Digital-Wandler jeweils eindeutig zugeteilt werden. Dadurch kann vorteilhafter Weise nur derjenige Analog-Digital-Wandler der Funktionsprüfung durch Sperrung unterzogen werden, bei dem dieses wenigstens eine analoge Signal jeweils mit nur einer Referenzspannung gewandelt werden soll.

Zweckmäßiger Weise wird die Funktionsprüfung an einem vorgegebenen analogen Testsignal durchgeführt, wobei in einer besonderen Ausgestaltung die Funktionsprüfung ausschließlich an dem vorgegebenen analogen Testsignal durchgeführt wird.

In einer zweckmäßigen Ausgestaltung, kann ein Analog-Digital-Wandler gemäß den vorgenannten Vorteilen in zwei Modi betrieben werden, wobei ein erster Modus oder Mode die Verwendung verschiedener Referenzspannung zur Wandlung gestattet und ein zweiter Modus oder Mode nur eine Referenzspannung zur Wandlung zulässt.

Vorteilhafter Weise erfolgt eine insbesondere softwaremäßige Zuordnung von Referenzspannungen durch wenigstens zwei Werte für verschiedene Referenzspannungen, die in einer Tabelle in einem Speicher abgelegt sind, wobei durch Auswahl eines Wertes eine Referenzspannung zur Verwendung bei der Wandlung vorgegeben wird.

Zweckmäßiger Weise kann dann die Funktionsprüfung, insbesondere durch das Separieren erster und zweiter Gruppen von Signalen nur für die erste Gruppe durchgeführt werden.

Damit kann vorteilhafter Weise eine fehlerhafte Konfiguration, insbesondere Modi-Einstellung des Analog-Digital-Wandlers erkannt werden. Das bedeutet, dass ein gesperrter Analog-Digital-Wandler weiterhin die Eigenschaft besitzt, alternative Referenzen zu benutzen, anstatt sie nicht zu benutzen, die Sperrung also nicht funktioniert.

Weiterhin müssen vorteilhafter Weise über die Absicherung des Analog-Digital-Wandler-Modes nicht alle Analog-Digital-Kanäle einzeln auf eine falsche Referenzspannung hin geprüft werden. Es genügt die Eigenschaft des Modes, der insbesondere hardwarebedingt auf alle Analog-Digital-Kanäle eines Analog-Digital-Wandlers bzw. einer Analog-Digital-Wandler-Bank gleichermaßen wirkt, exemplarisch an einem Kanal, insbesondere am Testspannungskanal zu prüfen.

Durch die erfindungsgemäße Erkennung einer falschen Modi-Einstellung im neuen Verfahren, welche eine Referenzumschaltung auf sicherheitsrelevanten Analog-Digital-Kanälen zulassen würde, wird die Nutzung einer zusätzlichen Referenzspannung aus sicherheitstechnischer Sicht zulässig. Mit der Nutzung der zusätzlichen Referenzspannung bzw. Referenz erreicht man eine erhebliche Reduzierung der Stoffkosten, da beispielsweise bisher in der Hardware diskret aufgebaute Schaltungsteile, wie zum Beispiel ein 4-fach-Verstärker, eines Istwert-Potentiometers durch Software bzw. durch Wandlung mit einer ¼-Referenz ersetzt werden kann.

Das Verfahren ist prinzipiell realisierbar ohne zusätzlichen Hardwareaufwand, insbesondere im Vergleich zum bisherigen Testspannungsverfahren, wie im Stand der Technik beschrieben.

Vorteilhafter Weise ist das Verfahren auch mit sehr geringem Software-Aufwand realisierbar.

Daneben ergibt sich eine eindeutige Diagnose, d.h. eine Fehlerzuordnung zum Analog-Digital-Wandler, welche komponentenunabhängig ist.

D.h. es erfolgt die Erkennung einer falschen Referenz bzw. eines falschen Analog-Digital-Wandler-Modes anhand einer tatsächlichen Analog-Digital-Wandlung, insbesondere einer Testspannung. Dies ist überwachungstechnisch sicherer, d.h. es müssen keine zusätzlichen Informationen aus den Mode-oder Konfigurationsregistern zur Auswertung verwendet werden, denn diese könnten zwar richtig ausgelesen werden, ob der defekte Analog-Digital-Wandler diese jedoch intern falsch weiterverarbeitet, kann daran nicht erkannt werden.

Vorteilhafter Weise werden weiterhin die bisherigen Fehlererkennungsmechanismen abgedeckt, das Verfahren ist somit eine Erweiterung zum Testspannungsverfahren, da zum Beispiel Analog-Digital-Wandler Steigungs- und Offsetfehler oder hängende Bitstellen im Analog-Digital-Wandlerergebnis durch die Abweichung vom Sollwert insbesondere der Testspannung erkannt werden können.

Weitere Vorteile und vorteilhafte Ausgestaltungen ergeben sich aus der Beschreibung sowie den Merkmalen der Ansprüche.

### Zeichnung

Die Erfindung wird im weiteren anhand der in der Zeichnung dargestellten Figuren näher erläutert.

### Dabei zeigt

Figur 1 einen Ausschnitt aus einem Steuergerät, welcher erfindungswesentliche Teile zeigt.

Figur 2 offenbart das erfindungsgemäße Verfahren anhand einer Vorrichtung in B lockschaltbilddarstellung.

In Figur 3 ist noch einmal kurz das erfindungsgemäße Verfahren anhand eines Flussdiagramms erläutert.

### Beschreibung der Ausführungsbeispiele

Die erfindungsgemäßen Rechnergenerationen, wie hier die Recheneinheit 100, haben nicht nur eine feste Referenzspannung UREF, wie beispielsweise 5 V, sondern besitzen zwei oder evtl. mehrere unterschiedliche Referenzspannung UREF1 und UREF2, usw. zur Verwendung im Rahmen der Analog-Digital-Wandlung. Erfindungsgemäß ist dabei auch die Möglichkeit gegeben, per Software jeder beliebigen Analog-Digital-Wandlung auf beliebigem Analog-Digital-Kanal eine dieser Referenzspannungen auszuwählen bzw. aufzuschalten.

Dabei entstehen nun neuartige Fehlerbilder, die in den bisherigen Rechnergenerationen nicht auftreten konnten, die jedoch im Sinne der Sicherheit beherrscht werden müssen, da eine fehlerhafte interne Referenzspannung bei einem A/D-Wandler zu einem falschen Wandlerergebnis führt.

D.h. als Ausgangspunkt, dass es für verschiedene Signale im Steuergerät vorteilhaft ist, gewisse Bereiche des Signals mit höherer Auflösung zu wandeln. Ein Beispiel hierfür ist das Drosselklappensignal im Leerlaufbereich eines Fahrzeugs, das dort heute mehrfach elektrisch verstärkt noch einmal eingelesen wird oder der Motortemperaturfühler, um eine höhere Auflösung, beispielsweise bei 100 Grad zu erreichen. Dabei ergibt sich das genannte kritische Fehlerbild aus Sicht der Überwachung, dass das Vorhandensein der Wandlung mit unterschiedlichen Referenzspannungen bei anderen Signalen, wie z.B. den Informationen aus dem Fahrpedalmodul, dazu führen könnte, dass beispielsweise beide Kanäle des Fahrpedalmoduls verstärkt eingelesen würden, womit beispielsweise das Fahrzeug selbst beschleunigt würde.

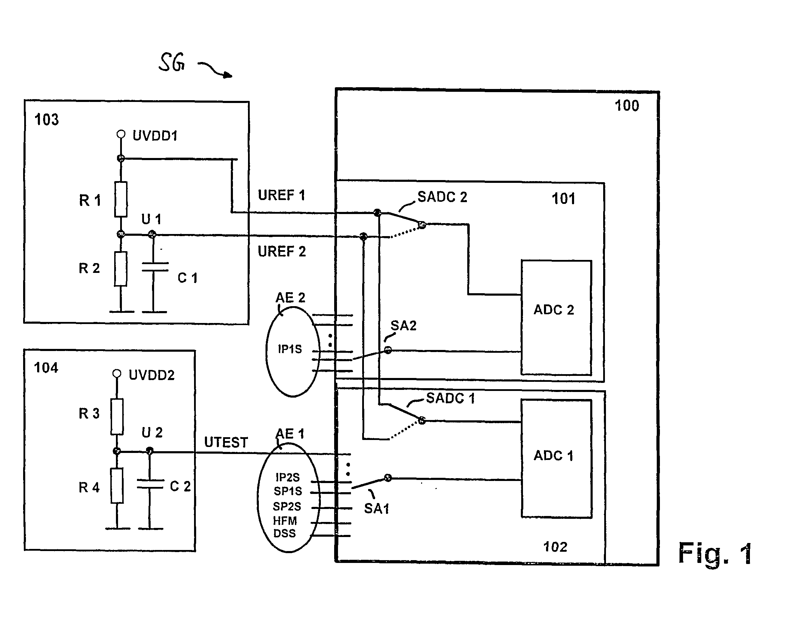

Verursacht ein Fehler die Wandlung mit einer falschen Referenz auf mehreren Kanälen wie z.B. SP1S und SP2S in Figur 1, so ist das Wandelergebnis auf jedem dieser Kanäle um denselben Verstärkungsfaktor falsch. Die bisherige Überwachungsfunktionen zur Absicherung dieser Signale beruhen auf der Plausibilisierung zweier Signale. Diese können dann solche genannten Fehler nicht detektieren, da das Verhältnis zueinander gleich bleibt, der Wert jedoch falsch ist.

Eine solche fehlerhafte Referenzspannung oder kürzer Referenz, kann durch Kurzschlüsse auf der Leiterplatte im Steuergerät, Hochohmigkeiten am PIN des IC's, also des integrierten Schaltkreises wie durch kalte Lötstelle oder Bonden, durch einen Speicherfehler, die zu einer falschen Analog-Digital-Wandlerkonfiguration führen oder auch durch interne Defekte in integrierten Schaltungen auf dem Rechner bzw. dem Analog-Digital-Wandler-Siliziumchip entstehen. Ebenso kann einfach ein falscher der verwendbaren Referenzwerte oder eine falsche Referenzspannung eingesetzt sein.

Da in den Fahrzeug-Steuergeräten, insbesondere in Motorsteuergeräten im Fahrzeug sicherheitsrelevante Signale wie beispielsweise der Fahrerwunsch durch das Fahrpedal vom Analog-Digital-Wandler gewandelt werden und diese Werte dem Steuergerät unmittelbar ein entsprechendes Motormoment im Motor des Kraftfahrzeugs einstellen, müssen solche Fehler sicher erkannt werden können. Dies gilt besonders für zu hohe Werte, da diese zu einer Selbstbeschleunigung, einem nicht beherrschbaren Fahrzustand oder einer Gefährdung von Personen führen könnte. Dies gilt ebenso für sicherheitskritische Situation in anderen Anwendungen, wie z.B. der Automatisierung oder im Werkzeugmaschienenbereich, usw.

Mit den bisherigen Analog-Digital-Wandler-Testverfahren können Fehler, die zu einer ungewollten Umschaltung und damit zu einer falschen Referenz führen, nicht erkannt werden. Die vorliegende Erfindung erfüllt somit die oben genannte Aufgabe, diese Fehler sicher zu erkennen und damit entsprechende Fehlerreaktionen auszuführen. Eine solche Fehlerreaktion ist beispielsweise eine gezielte Leistungsreduzierung im Falle der Motorsteuerung.

Dazu zeigt Figur 1 erfindungswesentliche Teile aus einem Steuergerät SG. Darin ist mit 100 eine Recheneinheit oder Steuereinheit, insbesondere ein Prozessor oder Mikrocomputer gezeigt. Dieser enthält mit 101 bzw. 102 integrierte Schaltkreise, die ihrerseits Analog-Digital-Wandler ADC1 bzw. ADC2 enthalten. Daneben sind Umschaltvorrichtungen SADC2 sowie SADC1 zur Umschaltung zwischen zwei Referenzspannungen UREF1 und UREF2 dargestellt. Verschiedene Analogeingangs(kanal)gruppen AE2 bzw. AE1 sind durch die dargestellten Schalter für die Analogsignale SA 1 bzw. SA2 umschaltbar.

Die Referenzspannungen UREF1 bzw. UREF2 werden aus einem Referenzspannungsgenerator entnommen, der mit 103 dargestellt ist. Darin ist eine Basisversorgungsspannung UVDD1 gezeigt, welche in diesem Beispiel UREF1 entspricht. Über einen Spannungsteiler mit den Widerständen R1 bzw. R2 sowie einer angekoppelten Kapazität C1 kann dann eine Spannung U1 bzw. UREF2 ebenfalls dem Block 103 entnommen werden. Neben dem dargestellten Beispiel im Block 103 mittels Spannungsteilung ist jede andere Möglichkeit zur Erzeugung der Referenzspannung, wie beispielsweise unterschiedliche Spannungsquellen oder einen tatsächlichen Referenzspannungsgenerator usw. erfindungsgemäß denkbar zur Erzeugung wenigstens zweier Referenzspannungen.

Gleiches gilt für die Erzeugung der Testspannung UTEST im Block 104. Darin ist eine Versorgungsspannung UVDD2 gezeigt, die gleich oder ungleich zu UVDD1 sein kann. Auch hier wird mittels Spannungsteilung eine Spannung U2, die hier der Testspannung UTEST entspricht, erzielt. Mit C2 ist eine Kapazität dargestellt. Auch hier kann die Testspannung UTEST auf beliebige Arten erzeugt werden, beispielhaft durch Spannungsteilung, aber wie oben auch genannt, sind andere Möglichkeiten gegeben.

Eine fehlerhafte interne Referenzspannung führt bei einem Analog-Digital-Wandler ADC zu einem falschen Wandelergebnis, obwohl am Analog-Digital-Kanal physikalisch eine unveränderte Spannung anliegt. Der Analog-Digital-Wandler ADC wandelt die Analogspannung immer relativ (ratiometrisch) zu seiner Referenzspannung. Ist die Referenzspannung, wie in der gewünschten Anwendung bei dem vorgenannten Steuergerät SG zum Beispiel um den Faktor 4 zu klein, so ist das Wandelergebnis um den Faktor 4 zu groß.

Das hier dargestellte Steuergerät SG ist beispielsweise ein Motorsteuergerät in einem Kraftfahrzeug oder auch ein anderweitiges Steuergerät in einem Fahrzeug bzw. ebenso im Werkzeugmaschinenbereich oder der Automatisierung denkbar. Darin eingesetzt ist ein Mikrocontroller 100 mit in diesem Beispiel zwei Referenzspannungseingängen (UREF1 und UREF2). Am Standardreferenzspannungseingang liegt beispielsweise eine Spannung von 5 V, hier UREF1. Am zweiten alternativen Referenzspannungseingang UREF2 liegt die über einen Spannungsteiler erzeugte alternative Referenzspannung von beispielsweise 1,2 V. Für andere Anwendungen sind auch andere Spannungswerte denkbar. Damit ergibt sich eine beispielhafte Dimensionierung der Bausteine im Spannungsteiler im Block 103 von R1 mit 31,6 kΩ, R2 mit 10 kΩ und C1 mit 100 nF (Für UREF1 von 5V und UREF2 von 1,2V).

Der Mikrocontroller 100 hat zwei Analog-Digital-Wandler-Bänke bzw. Analog-Digital-Wandler ADC1 bzw. ADC2 beispielsweise mit je 16 Analog-Digital-Kanälen auf dem Rechnerchip. Die Analogeingänge bzw. die Analogkanäle sind mit AE2 für ADC2 bezeichnet und beispielhaft ist darin einer mit IP1F bezeichnet. Diese sind über den Schalter SA2 umschaltbar. Die Analogeingänge AE1 oder Analog-Digital-Kanäle AE1 umfassen die Kanäle UTEST, IP2S, SP1S, SP2S, HFM und DSS, usw. Dies sind beispielsweise Sensorsignale vom Heißfilmluftmassenmesser HFM oder auch Drehzahlsignale wie DSS sowie von weiterer Sensorik oder auch weiteren Steuergeräten oder Teilnehmern im Rahmen eines Steuergeräteverbundes. Die Funktionsprüfung kann mit wenigstens einem von diesen Signalen, insbesondere dem Testsignal durchgeführt werden.

Das Testsignal mit dem beispielsweise, wie nachher noch beschrieben, die Funktionsprüfung durchgeführt werden kann, wird im Block 104 generiert, beispielsweise auch hier über einen Spannungsteiler mit R3, R4 aus einer Spannung UVDD2. Auch hier wird beispielhaft eine Dimensionierung gewählt, mit R3 = 3,83 kΩ und R4 = 10 kΩ sowie C2 22 nF, was zu einer Testspannung UTEST von 3,6 V führt.

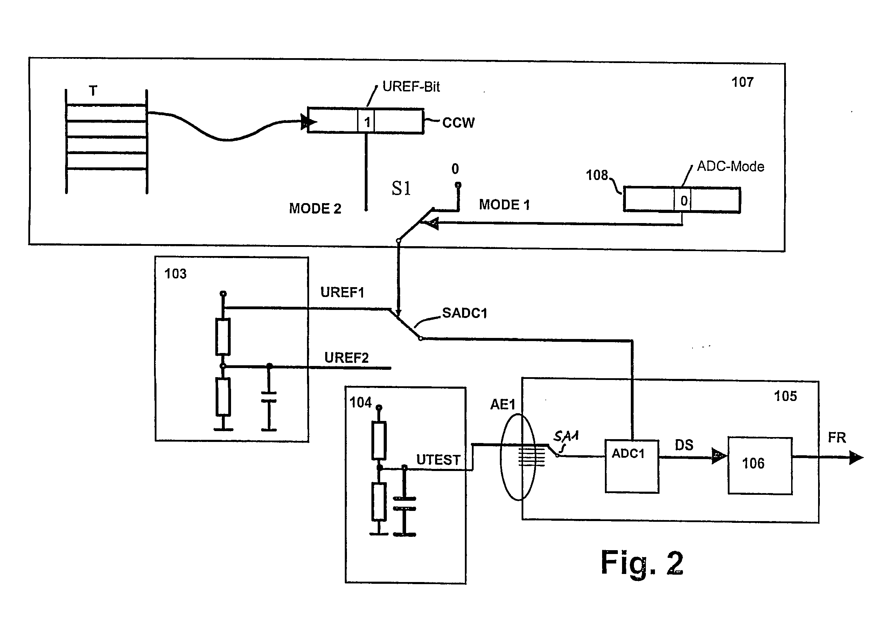

Das eigentliche Testverfahren bzw. die Funktionsprüfung und die Modieinstellungen werden nun in Figur 2 beschrieben. Dabei stehen im Block 107 zwei Modi, also zwei Modeeinstellungen zur Verfügung, MODE1 und MODE2, welche jeweils die Eigenschaft der Analog-Digital-Wandler bezüglich der Referenzspannung für eine komplette Bank, also beispielsweise für 16 Analog-Digital-Kanäle bestimmen. Dabei bedeutet der MODE1, dass alle Analog-Digital-Kanäle der Bank für Analog-Digital-Wandlungen mit UREF2 gesperrt sind. Der MODE2 bedeutet, dass alle Analog-Digital-Kanäle der Bank Analog-Digital-Wandlungen mit UREF1 oder mit UREF2 durchführen können. Hier dargestellt, kann für jede Analog-Digital-Wandlung per Software im Betrieb im MODE2 zwischen den hier zwei Referenzen UREF 1 und UREF2 ausgewählt werden. Dazu werden alle Analog-Digital-Wandlungen, die ausgeführt werden sollen, in einer Tabelle T, insbesondere einer Tabelle in einem Speicher, einer Speichertabelle T, definiert. Wobei sich der Speicher ebenfalls im Steuergerät insbesondere auf dem Mikrocontroller 100 befindet.

Hier kann durch Setzen einer bestimmten Bit-Position beispielsweise in einem Register CCW die gewünschte Referenzspannung gewählt werden, die dann bei dieser Wandlung verwendet wird. Die in diesem Beispiel verwendete Bit-Position ist das UREF-BIT, das hier in diesem Beispiel, da nur zwei Referenzspannungen verwendet werden, ausreicht. Bei Einsatz mehrerer Referenzspannung sind entsprechend mehrere Bits zu wählen. Die Modeumschaltung erfolgt beispielsweise heraus aus einem Register 108, bei welchem ein bestimmtes Bit, hier das ADC-Mode-Bit gesetzt oder nicht gesetzt ist und demnach der MODE1 oder der MODE2 gewählt wird. Auch hier beim Wählen mehrerer Modi über zwei hinausgehend müssten mehr Bits als das eine Bit zur Modiumschaltung gewählt werden. So können bestimmten Modis unterschiedliche Referenzspannungen, die zur Wandlung eingesetzt werden können, zugeordnet sein.

Mit Block 103 ist wiederum der aus Figur 1 bekannte Referenzspannunggenerator dargestellt. Gleiches gilt für den Testspannungsgenerator in Block 104.

Die Modewahl wird symbolisch durch den Schalter S 1 repräsentiert, durch welchen dann Einfluss auf den Schalter SADC1 zur Auswahl der entsprechenden Referenz erfolgt. Mit AE1 sind wieder die Analogeingänge der Analog-Digital-Kanäle hier für die Analog-Digital-Bank bzw. den Analog-Digital-Wandler ADC1 dargestellt. Dieser gibt ein digitales Signal DS aus, dass dann in dem Block 106 ausgewertet werden kann, woraus sich dann eine Fehlerreaktion FR ergibt. Dies ist zusammenfassend im Block 105 dargestellt. Die Blöcke 107, 103, 104 und 105 sind Teil des Steuergerätes SG, insbesondere sind die Blöcke 107 und 105 in einer vorteilhaften Ausgestaltung Teil des Mikrocontrollers 100.

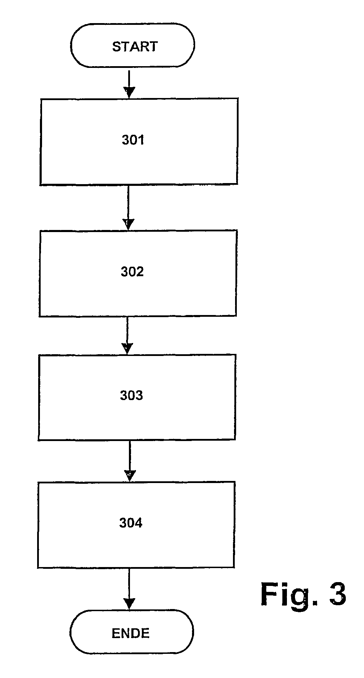

Figur 3 zeigt nun unter Bezugnahme auf die Figuren 1 und 2 einen möglichen erfindungsgemäßen Verfahrensablauf.

Das Verfahren besteht aus einer hardwaremäßigen Auslegungsvorschrift, die erfüllt werden sollte und einer darauf abgestimmten Konfiguration des Analog-Digital-Wandlers und entsprechendem Softwareablauf.

Die Hardwareauslegungsvorschrift beinhaltet zunächst eine Kanalfestlegung. Hier werden alle sicherheitsrelevanten Signale, die von einer falschen Referenzspannung geschützt werden sollen, auf einen Analog-Digital-Wandler bzw. auf eine Analog-Digital-Wandler-Bank (ADC-Bank) gelegt, wie beispielsweise SP1S, SP2S, IP2S, HFM und DSS auf die ADC-Bank ADC1. Die Testspannung UTEST, mit der die richtige Modeeinstellung für diese Bank geprüft werden kann, muss dann auch an dieser ADC-Bank anliegen. Alle Signale, die die alternative Referenz funktional verwenden sollen, werden dann auf wenigstens eine andere ADC-Bank gelegt. Im vorliegenden Anwendungsfall entspricht dies einer ADC-Bank mit 16 Analog-Digital-Kanälen. Bei anderen Rechnern bzw. Analog-Digital-Wandlern kann dies auch einer bestimmten ADC-Kanal gruppe, auf der doch eine feste Vorgabe keine ADC-Wandlung mit alternativer Referenz möglich sind, sein. D.h. neben einer Bankeinteilung kann auch eine reine Einteilung in eine Gruppe erster Signale und eine Gruppe zweiter Signale usw. erfolgen.

Die Konfiguration und der Softwareablauf entstehend gemäß Figur 2 in Block 301. Darin wird zum einen die Analog-Digital-Wandler-Eigenschaften der ADC-Bänke bzw. der Signalgruppen festgelegt. Dies erfolgt typischerweise einmal im Systemhochlauf, also bei der Initialisierung und gilt dann für den gesamten Zyklus, insbesondere Fahrzyklus. Beispielsweise wird hier die Konfiguration ADC-Wandler 1 im MODE1, also Wandlung mit alternativer Referenz gesperrt und der ADC-Wandler ADC2 im MODE2, also Wandlung mit alternativer Referenz erlaubt, betrieben.

Danach erfolgt in Block 302 die Wandlung beispielsweise der Testspannung als Repräsentant der AE1-Gruppe mit Vorgabe alternativer Referenzspannung. D.h. bei korrekter Mode-Einstellung ist die Wandlung mit der alternativen Referenz nicht wirksam, sondern wird mit der Standardreferenz gewandelt. Die Vorgabe dient jedoch als Kontrollmechanismus, um einen fehlerhaft wirksamen Mode zu erkennen.

Danach erfolgt in Block 303 die Prüfung der Testspannung, also des aus der analogen Testspannung gewandelten digitalen Wertes, insbesondere unter Hinzunahme eines Toleranzbandes von UMIN < UTEST < UMAX. Dieser Test kann nun dahingehend erfolgen, dass wie bereits in den Vorteilen beschrieben, das analoge Signal insbesondere die Testspannung UTEST unter Verwendung der ersten Referenzspannung UREF1 gewandelt wird und zur Funktionsprüfung, das unter Verwendung der ersten Referenzspannung gewandelte digitale Signal DS mit einem unter Verwendung der ersten Referenzspannung UREF1 erwarteten vorgegebenen Signal DSREF1 ausgewertet wird entsprechend einer Normalprüfung oder eines Normalvergleichs.

Andererseits kann nun auch ein analoges Signal unter Verwendung der ersten Referenzspannung UREF1 gewandelt werden also insbesondere die Testspannung UTEST wobei zur Funktionsprüfung das unter Verwendung der ersten Referenzspannung UREF1 gewandelte digitale Signal DS mit einem unter Verwendung der zweiten Referenzspannung UREF2 erwarteten vorgegebenen Signal DSREF2 ausgewertet wird also eine Kreuzprüfung bzw. ein Kreuzvergleich.

Fehlerreaktionen können nun in beiden Fällen der Normal- sowie der Kreuzprüfung dahingehend abgeleitet werden, dass die Identität bei dem Vergleich im Rahmen des Toleranzbandes eine Fehlerreaktion auslöst oder die Ungleichheit im Rahmen des Vergleichs eine Fehlerreaktion auslöst.

Eine Fehlerreaktion ist also je nach Anwendung z.B. dann auszulösen wenn
- DSREF1 ungleich DS mit UREF1
- DSREF2 gleich DS mit UREF1, usw.
wobei DS insbesondere innerhalb des besagten Toleranzbandes liegen dürfte, welches sich bei digitalen Signalen als DSMIN < DS mit UREF1 < DSMAX und im wesentlichen aus Toleranzen im analogen Signal UTEST ergibt.

Bei Ungleichheit erfolgt dann bei Werten insbesondere außerhalb des Toleranzbandes eine entsprechende Fehlerreaktion. Bei Anwendung des Gleichheitskriteriums erfolgt also eine Fehlerreaktion bei Werten insbesondere innerhalb des Toleranzbandes. Die gewünschte Genauigkeit kann durch Vorgabe einer Toleranz erfolgen die im Extremfall auch mit Null angegeben werden kann.

Als Fehlerreaktion in Block 304 sind dabei insbesondere eine Leistungsreduzierung im Rahmen der Motorsteuerung, das Starten bestimmter Notlaufprogramme insbesondere mit fest eingestellten Bedingungen oder auch Abschalten bestimmter Funktionen, u. s. w. denkbar. Dabei kann die Fehlerreaktion abhängig vom gewandelten digitalen Signal oder der daraus rückgerechneten Referenzspannung erfolgen, wie z.B. abhängig von der Höhe der Abweichung vom erwarteten Wert unterschiedlich. Von schwachen Maßnahmen bei geringer Abweichung bis Funktionsabschaltung und Notlauf bei höheren Abweichungen. Dazu können dann neben dem Toleranzband weitere Schwellwertbereiche für verschiedene Fehlerreaktionen festgelegt werden.

Dabei kann die Überprüfung anhand eines Vergleichs der Digitalen aus den analogen Werten gewandelten Signale mit einem Ziel- bzw. Sollwert erfolgen oder durch Vergleich der Referenzspannungswerte bei einem Rückrechnen der Referenzspannung aus dem gewandelten digitalen Signal DS.

Die Konfiguration des Modes ist mit dem Schalter S 1 dargestellt in Figur 2. Mit diesem Schalter kann also zwischen den beiden Moden Mode 1 und Mode 2 gewählt werden. In Mode 1 sind nur Wandlungen mit der Standardreferenz z. B. 5 Volt UREF1 möglich. In Mode 2 kann jede beliebige AD-Wandlung entsprechend der Definition in der Tabelle T hier wählbar durch das UREFBIT im Register CCW eine Referenzspannung auswählen. Dies ist dann mit dem Schalter SADC 1 dargestellt.

Da die Referenzen beliebigen Analog-Digital-Wandlungen zuordenbar sind, hat eine Prüfung der Referenz auf dem Testspannungskanal normalerweise keine Aussagekraft über den Zustand bzw. die Referenz eines anderen Kanals. Eine Plausibilisierung aller Signale auf korrekter Referenz ist mit hohem Aufwand verbunden oder ist nicht realisierbar. Deshalb wird in dem dargestellten Verfahren erfindungsgemäß die Möglichkeit verwendet bestimmte Kanalgruppen durch eine bestimmte Modeeinstellung von der Fähigkeit der Wandlung mit einer alternativen Referenz zu sperren. Dabei kann durch geeignete Wahl erzielt werden, dass ganze Kanalgruppen insgesamt an einen eingestellten Mode gebunden werden, insbesondere durch die Rechenhardware. Wird nun der Modezustand beispielhaft an einem Kanal insbesondere dem Testkanal UTEST geprüft, kennt man damit die Kanaleigenschaft der gesamten Kanalgruppe AE1. Dabei können mehrere Kanalgruppen vorgesehen sein, die jeweils nur mit einer Referenz zu wandeln sind. Dann sollte pro Kanalgruppe ein Testkanal mit entsprechender Referenz vorgesehen sein. Dabei ist aus eine interne, insbesondere softwaremäßige Umschaltung zwischen Testkanälen und den zugehörigen Referenzen denkbar.

Dabei wird der Modezustand nicht durch Auslesen des ADC-Modes selbst geprüft (Register 108) sondern eine tatsächliche Analog-Digital-Wandlung insbesondere mit Hilfe der Testspannung dazu verwendet. Die Aussage über den Modezustand ist in dem Wandelergebnis dann bereits enthalten, da die Analog-Digital-Wandlung mit der Einstellung für Wandlung mit Alternativreferenz also dem UREFBIT = 1 durchgeführt wird. Die Analog-Digital-Wandlung kann bei richtiger Modeeinstellung MODE1 trotz einem UREFBIT = 1 keine Wandlung mit Altemativereferenz UREF2, sondern nur mit der Standardreferenz UREF 1 von beispielsweise 5 Volt durchführen. Das Ergebnis ist dann richtig und entspricht dem erwarteten Testspannungswert. Wäre die Modeeinstellung fehlerhaft oder würde der ADC eine Analog-Digital-Wandlung mit einer falschen Referenz, insbesondere UREF2, durchführen wäre das Ergebnis falsch und sofort am gewandelten Testspannungswert erkennbar. Gleiches gilt für eine fehlerhaft veränderte Referenz wie eingangs erwähnt, die nicht der Alterbnativreferenz entspricht.

Das hier dargestellte Ausführungsbeispiel soll die erfindungsgemäßen Möglichkeiten nicht begrenzen, sondern einige Aufzeigen. Das erfindungsgemäße Verfahren und die Vorrichtung sowie der Analog-Digital-Wandler erstreckt sich auf alle hierbei denkbaren Möglichkeiten, insbesondere bezüglich Gleichheits- und Ungleichheitstest bei Kreuz- und Normalprüfung oder insbesondere dem Einsatz verschiedener Kanäle und Kanalgruppen mit erlaubten ein oder mehr Referenzen, usw.

## Patentansprüche

1. Verfahren zur Funktionsprüfung eines Analog-Digital-Wandlers (ADC1, ADC2), wobei der Analog-Digital-Wandler (ADC1, ADC2) eine Funktion zur Wandlung wenigstens eines analogen Signals in wenigstens ein digitales Signal unter Verwendung einer ersten vorgegebenen Referenzspannung (UREF1) durchführt, wobei der Analog-Digital-Wandler (ADC1, ADC2) in wenigstens zwei Modi betrieben wird und die Funktion in wenigstens einem ersten Modus alternativ unter Verwendung wenigstens einer weiteren, insbesondere einer vorgegebenen zweiten, Referenzspannung (UREF2), durchführen kann, wobei in wenigstens einem zweiten Modus eine Verwendung wenigstens der weiteren Referenzspannung (UREF2) durch den Analog-Digital-Wandler (ADC1, ADC2) verhindert wird, wobei zur Funktionsprüfung im zweiten Modus ein vorgegebenes analoges Signal in ein digitales Signal gewandelt wird und das digitale Signal ausgewertet wird und damit die Funktion überprüft wird, **dadurch gekennzeichnet, dass** bei Auswahl des vorgegebenen analogen Signals zur Funktionsprüfung als Eingangssignal die Verwendung wenigstens der weiteren Referenzspannung (UREF2) durch den Analog-Digital-Wandler (ADC1, ADC2) nicht möglich ist und dass bei nicht erfolgter Auswahl des vorgegebenen analogen Signals als Eingangssignal die Verwendung wenigstens der weiteren Referenzspannung (UREF2) durch den Analog-Digital-Wandler (ADC1, ADC2) möglich ist.

2. Verfahren nach Anspruch 1, **dadurch gekennzeichnet, dass** ein analoges Signal unter Verwendung der ersten Referenzspannung gewandelt wird und zur Funktionsprüfung das unter Verwendung der ersten Referenzspannung gewandelte digitale Signal mit einem unter Verwendung der ersten Referenzspannung erwarteten, vorgegebenen Signal ausgewertet wird.

3. Verfahren nach Anspruch 1, **dadurch gekennzeichnet, dass** ein analoges Signal unter Verwendung der ersten Referenzspannung gewandelt wird und zur Funktionsprüfung das unter Verwendung der ersten Referenzspannung gewandelte digitale Signal mit einem unter Verwendung der zweiten Referenzspannung erwarteten, vorgegebenen Signal ausgewertet wird.

4. Verfahren nach Anspruch 1 oder 2 oder 3, **dadurch gekennzeichnet, dass** zur Funktionsprüfung aus dem digitalen Signal, das aus dem vorgegeben analogen Signal gewandelt wurde, die zur Wandlung verwendete Referenzspannung ermittelt wird und die ermittelte, zur Wandlung verwendete Referenzspannung mit wenigstens einer vorgegebenen Referenzspannung verglichen wird.

5. Verfahren nach Anspruch 1 oder 2 oder 3, **dadurch gekennzeichnet, dass** zur Funktionsprüfung das aus dem vorgegebenen analogen Signal gewandelte digitale Signal mit wenigstens einem erwarteten digitalen Signal verglichen wird.

6. Verfahren nach Anspruch 4, **dadurch gekennzeichnet, dass** abhängig von dem Vergleich der ermittelten Referenzspannung mit der wenigstens einen vorgegebenen Referenzspannung auf Fehler erkannt wird und eine vorgegebene Fehlerreaktion erfolgt, wobei die Fehlerreaktion insbesondere abhängig von der ermittelten Referenzspannung ist.

7. Verfahren nach Anspruch 5, **dadurch gekennzeichnet, dass** abhängig von dem Vergleich des aus dem vorgegebenen analogen Signal gewandelten digitalen Signals mit dem wenigstens einen erwarteten digitalen Signal auf Fehler erkannt wird und eine vorgegebene Fehlerreaktion erfolgt, wobei die Fehlerreaktion insbesondere abhängig von dem, aus dem vorgegebenen analogen Signal gewandelten digitalen Signal ist.

8. Verfahren nach Anspruch 6 oder 7, **dadurch gekennzeichnet, dass** eine Fehlerreaktion erfolgt wenn bei dem Vergleich keine Übereinstimmung innerhalb einer vorgebbaren Toleranz erzielt wird.

9. Verfahren nach Anspruch 6 oder 7, **dadurch gekennzeichnet, dass** eine Fehlerreaktion erfolgt wenn bei dem Vergleich Übereinstimmung innerhalb einer vorgebbaren Toleranz erzielt wird.

10. Verfahren nach Anspruch 1, **dadurch gekennzeichnet, dass** dem Analog-Digital-Wandler wenigstens zwei analoge Signale zur Wandlung zuführbar sind und wenigstens einem der wenigstens zwei analogen Signale nur genau eine Referenzspannung zur Wandlung zugeordnet wird.

11. Verfahren nach Anspruch 1, **dadurch gekennzeichnet, dass** wenigstens ein erstes analoges Signal als eine erste Gruppe von ersten Signalen gewandelt wird, welchen nur genau eine Referenzspannung zur Wandlung zugeordnet ist und wenigstens ein zweites analoges Signal als eine zweite Gruppe von zweiten Signalen gewandelt wird, welchem wenigstens zwei Referenzspannungen zur Wandlung zuordenbar sind.

12. Verfahren nach Anspruch 11, **dadurch gekennzeichnet, dass** die erste Gruppe von ersten analogen Signalen einem ersten Analog-Digital-Wandler (ADC1) und die zweite Gruppe von zweiten analogen Signalen einem zweiten Analog-Digital-Wandler (ADC2) zugeordnet wird.

13. Verfahren nach Anspruch 1, **dadurch gekennzeichnet, dass** die Funktionsprüfung an einem vorgegebenen analogen Testsignal durchgeführt wird.

14. Verfahren nach Anspruch 1, **dadurch gekennzeichnet, dass** die Funktionsprüfung ausschließlich an einem vorgegebenen analogen Testsignal durchgeführt wird.

15. Verfahren nach Anspruch 1, **dadurch gekennzeichnet, dass** der Analog-Digital-Wandler in zwei Modi betrieben werden kann, wobei ein erster Modus die Verwendung verschiedener Referenzspannungen zur Wandlung gestattet und ein zweiter Modus nur eine Referenzspannung zur Wandlung zuläßt.

16. Verfahren nach Anspruch 1, **dadurch gekennzeichnet, dass** wenigstens zwei Werte für verschiedene Referenzspannungen in einer Tabelle in einem Speicher abgelegt sind und durch Auswahl eines Wertes eine Referenzspannung zur Verwendung bei der Wandlung vorgegeben wird.

17. Verfahren nach Anspruch 11, **dadurch gekennzeichnet, dass** die Funktionsprüfung nur für die erste Gruppe der ersten analogen Signale durchgeführt wird.

18. Vorrichtung zur Funktionsprüfung eines Analog-Digital-Wandlers(ADC1, ADC2), wobei der Analog-Digital-Wandler (ADC1, ADC2) eine Funktion zur Wandlung wenigstens eines analogen Signals in wenigstens ein digitales Signal unter Verwendung einer ersten vorgegebenen Referenzspannung (UREF1) aufweist, wobei die Vorrichtung derart ausgestaltet ist, dass der Analog-Digital-Wandler (ADC1, ADC2) in wenigstens zwei Modi betrieben wird und die Funktion in wenigstens einem ersten Modus alternativ unter Verwendung wenigstens einer weiteren, insbesondere einer vorgegebenen zweiten, Referenzspannung(UREF2), durchführen kann, wobei Mittel vorgesehen sind durch die in wenigstens einem zweiten Modus eine Verwendung wenigstens der weiteren Referenzspannung durch den Analog-Digital-Wandler (ADC1, ADC2) verhindert wird, wobei zur Funktionsprüfung im zweiten Modus ein vorgegebenes analoges Signal in ein digitales Signal gewandelt wird und das digitale Signal ausgewertet wird und damit die Funktion überprüft wird, **dadurch gekennzeichnet, dass** Mittel vorgesehen sind durch die bei Auswahl des vorgegebenen analogen Signals zur Funktionsprüfung als Eingangssignal die Verwendung wenigstens der weiteren Referenzspannung (UREF2) durch den Analog-Digital-Wandler (ADC1, ADC2) nicht möglich ist und bei nicht erfolgter Auswahl des vorgegebenen analogen Signals als Eingangssignal die Verwendung wenigstens der weiteren Referenzspannung (UREF2) durch den Analog-Digital-Wandler (ADC1, ADC2) möglich ist.

## Claims

1. Method for functionally testing an analogue-to-digital converter (ADC1, ADC2), the analogue-to-digital converter (ADC1, ADC2) performing a function for converting at least one analogue signal into at least one digital signal using a first predefined reference voltage (UREF1), the analogue-to-digital converter (ADC1, ADC2) being operated in at least two modes and being able to alternatively perform the function in at least one first mode using at least one further, in particular a predefined second, reference voltage (UREF2), the analogue-to-digital converter (ADC1, ADC2) being prevented from using at least the further reference voltage (UREF2) in at least one second mode, a predefined analogue signal being converted into a digital signal and the digital signal being evaluated and the function thus being checked in order to test the function in the second mode, **characterized in that**, when the predefined analogue signal for testing the function is selected as the input signal, the analogue-to-digital converter (ADC1, ADC2) cannot use at least the further reference voltage (UREF2), and **in that**, when the predefined analogue signal is not selected as the input signal, the analogue-to-digital converter (ADC1, ADC2) can use at least the further reference voltage (UREF2).

2. Method according to Claim 1, **characterized in that** an analogue signal is converted using the first reference voltage, and, in order to test the function, the digital signal converted using the first reference voltage is evaluated using a predefined signal which is expected using the first reference voltage.

3. Method according to Claim 1, **characterized in that** an analogue signal is converted using the first reference voltage, and, in order to test the function, the digital signal converted using the first reference voltage is evaluated fusing a predefined signal which is expected using the second reference voltage.

4. Method according to Claim 1 or 2 or 3, **characterized in that**, in order to test the function, the reference voltage used for conversion is determined from the digital signal which was converted from the predefined analogue signal, and the reference voltage which is determined and was used for conversion is compared with at least one predefined reference voltage.

5. Method according to Claim 1 or 2 or 3, **characterized in that**, in order to test the function, the digital signal converted from the predefined analogue signal is compared with at least one expected digital signal.

6. Method according to Claim 4, **characterized in that** errors are detected on the basis of the comparison of the reference voltage determined with the at least one predefined reference voltage, and a predefined error reaction takes place, the error reaction being dependent, in particular, on the reference voltage determined.

7. Method according to Claim 5, **characterized in that** errors are detected on the basis of the comparison of the digital signal, which has been converted from the predefined analogue signal, with the at least one expected digital signal, and a predefined error reaction takes place, the error reaction being dependent, in particular, on the digital signal which has been converted from the predefined analogue signal.

8. Method according to Claim 6 or 7, **characterized in that** an error reaction takes place if correspondence within a predefinable tolerance is not achieved during the comparison.

9. Method according to Claim 6 or 7, **characterized in that** an error reaction takes place if correspondence within a predefinable tolerance is achieved during the comparison.

10. Method according to Claim 1, **characterized in that** at least two analogue signals can be supplied to the analogue-to-digital converter for the purpose of conversion, and only precisely one reference voltage is assigned to at least one of the at least two analogue signals for the purpose of conversion.

11. Method according to Claim 1, **characterized in that** at least one first analogue signal is converted as a first group of first signals which are assigned only precisely one reference voltage for the purpose of conversion, and at least one second analogue signal is converted as a second group of second signals which can be assigned at least two reference voltages for the purpose of conversion.

12. Method according to Claim 11, **characterized in that** the first group of first analogue signals is assigned to a first analogue-to-digital converter (ADC1) and the second group of second analogue signals is assigned to a second analogue-to-digital converter (ADC2).

13. Method according to Claim 1, **characterized in that** the functional test is carried out on a predefined analogue test signal.

14. Method according to Claim 1, **characterized in that** the functional test is carried out exclusively on a predefined analogue test signal.

15. Method according to Claim 1, **characterized in that** the analogue-to-digital converter can be operated in two modes, a first mode allowing different reference voltages to be used for the purpose of conversion and a second mode allowing only one reference voltage for the purpose of conversion.

16. Method according to Claim 1, **characterized in that** at least two values for different reference voltages are stored in a table in a memory and a reference voltage for use during conversion is predefined by selecting a value.

17. Method according to Claim 11, **characterized in that** the functional test is carried out only for the first group of first analogue signals.

18. Device for functionally testing an analogue-to-digital converter (ADC1, ADC2), the analogue-to-digital converter (ADC1, ADC2) having a function for converting at least one analogue signal into at least one digital signal using a first predefined reference voltage (UREF1), the device being configured in such a manner that the analogue-to-digital converter (ADC1, ADC2) is operated in at least two modes and is able to alternatively perform the function in at least one first mode using at least one further, in particular a predefined second, reference voltage (UREF2), provision being made of means which prevent the analogue-to-digital converter (ADC1, ADC2) from using at least the further reference voltage in at least one second mode, a predefined analogue signal being converted into a digital signal and the digital signal being evaluated and the function thus being checked in order to test the function in the second mode, **characterized in that** provision is made of means which, when the predefined analogue signal for testing the function is selected as the input signal, make it impossible for the analogue-to-digital converter (ADC1, ADC2) to use at least the further reference voltage (UREF2), and, when the predefined analogue signal is not selected as the input signal, make it possible for the analogue-to-digital converter (ADC1, ADC2) to use at least the further reference voltage (UREF2).

## Revendications

1. Procédé de contrôle du fonctionnement d'un convertisseur analogique/numérique (ADC1, ADC2) selon lequel le convertisseur analogique/numérique (ADC1, ADC2) exécute une fonction de conversion d'au moins un signal analogique en au moins un signal numérique en utilisant une première tension de référence prédéfinie (UREF1),
le convertisseur analogique/numérique (ADC1, ADC) fonctionnant selon au moins deux modes et le fonctionnement dans au moins un premier mode se faisant de manière alternative en utilisant au moins une autre tension de référence (UREF2), notamment une seconde tension de référence prédéfinie,
et dans le second mode on évite l'utilisation de l'autre tension de référence (UREF2) par le convertisseur analogique/numérique (ADC1, ADC2), et
pour le contrôle du fonctionnement dans le second mode, on convertit un signal analogique prédéfini en un signal numérique et on exploite le signal numérique pour vérifier le fonctionnement,
**caractérisé en ce que**
dans la sélection du signal analogique prédéfini pour vérifier le fonctionnement, il n'est pas possible d'utiliser comme signal d'entrée l'autre tension de référence (UREF2) par le convertisseur analogique/numérique (ADC1, ADC2) et
lors de la sélection réussie du signal analogique prédéfini, comme signal d'entrée il est possible d'utiliser l'autre tension de référence (UREF) par le convertisseur analogique/numérique (ADC1, ADC2).

2. Procédé selon la revendication 1,
**caractérisé en ce que**
le signal analogique est converti en utilisant la première tension de référence et pour contrôler le fonctionnement on exploite le signal numérique converti en utilisant la première tension de référence avec un signal prédéfini, prévisible, obtenu en utilisant la première tension de référence.

3. Procédé selon la revendication 1,
**caractérisé en ce qu'**
on convertit un signal analogique en utilisant la première tension de référence et on l'exploite pour contrôler le fonctionnement du signal numérique converti en utilisant la première tension de référence, avec un signal prédéfini prévisible, obtenu en utilisant la seconde tension de référence.

4. Procédé selon la revendication 1 ou 2 ou 3,
**caractérisé en ce que**
pour le contrôle du fonctionnement, à partir du signal numérique obtenu par la conversion du signal analogique prédéfini, on détermine la tension de référence utilisée pour la conversion et on compare la tension de référence déterminée, utilisée pour la conversion, à au moins une tension de référence prédéfinie.

5. Procédé selon les revendications 1 ou 2 ou 3,
**caractérisé en ce que**
pour le contrôle du fonctionnement, on compare le signal numérique converti à partir du signal analogique prédéfini, à au moins un signal numérique prévisible.

6. Procédé selon la revendication 4,
**caractérisé en ce qu'**
on détecte un défaut en fonction de la comparaison de la tension de référence obtenue avec au moins une tension de référence prédéfinie, et on a une réaction de défaut prédéfinie, qui dépend notamment de la tension de référence prédéfinie.

7. Procédé selon la revendication 5,
**caractérisé en ce qu'**
on détecte un défaut en fonction de la comparaison du signal numérique converti à partir du signal analogique prédéfini et avec au moins le signal numérique prévisible, et on effectue une réaction de défaut prédéfinie, qui dépend notamment du signal numérique prévu résultant de la conversion du signal analogique prédéfini.

8. Procédé selon la revendication 6 ou 7,
**caractérisé en ce qu'**
on a une réaction de défaut si la comparaison ne donne aucune concordance dans une plage de tolérance prédéfinie.

9. Procédé selon la revendication 6 ou 7,
**caractérisé en ce qu'**
on a une réaction de défaut si la comparaison donne une concordance pour une tolérance prédéfinie.

10. Procédé selon la revendication 1,
**caractérisé en ce que**
le convertisseur analogique/numérique reçoit au moins deux signaux analogiques pour leur conversion et à au moins l'un des deux signaux analogiques, on associe seulement une tension de référence précise pour la conversion.

11. Procédé selon la revendication 1,
**caractérisé en ce qu'**
on convertit au moins un premier signal analogique comme premier groupe de premiers signaux auxquels est associée seulement une tension de référence précise pour la conversion et on convertit au moins un second signal analogique comme second groupe de seconds signaux en lui associant au moins deux tensions de référence pour la conversion.

12. Procédé selon la revendication 11,
**caractérisé en ce que**
le premier groupe des premiers signaux analogiques est associé à un premier convertisseur analogique/numérique (ADC1) et le second groupe de seconds signaux analogiques est associé à un second convertisseur analogique/numérique (ADC2).

13. Procédé selon la revendication 1,
**caractérisé en ce qu'**
on effectue le contrôle de fonctionnement avec un signal de test analogique prédéfini.

14. Procédé selon la revendication 1,
**caractérisé en ce qu'**
on effectue le contrôle de fonctionnement exclusivement avec un signal de test analogique prédéfini.

15. Procédé selon la revendication 1,
**caractérisé en ce qu'**
on fait fonctionner le convertisseur analogique/numérique en deux modes de fonctionnement, dans le premier mode de fonctionnement on permet l'utilisation de différentes tensions de référence pour la conversion et dans le second mode de fonctionnement on n'autorise qu'une tension de référence pour la conversion.

16. Procédé selon la revendication 1,
**caractérisé en ce qu'**
on enregistre au moins deux valeurs pour les différentes tensions de référence dans un tableau dans une mémoire et par la sélection d'une valeur, on prédéfinit une tension de référence utilisée pour la conversion.

17. Procédé selon la revendication 11,
**caractérisé en ce qu'**
on effectue le contrôle de fonctionnement seulement pour le premier groupe des premiers signaux analogiques.

18. Dispositif de contrôle du fonctionnement d'un convertisseur analogique/numérique (ADC1, ADC2), selon lequel le convertisseur analogique/numérique (ADC1, ADC2) a une fonction de conversion d'au moins un signal analogique en au moins un signal numérique en utilisant une première tension de référence prédéfinie (UREF1),
le dispositif étant réalisé pour que le convertisseur analogique/numérique (ADC1, ADC2) fonctionne dans au moins deux modes et le fonctionnement se fait dans au moins un premier mode en alternative, en utilisant au moins une autre tension de référence (UREF2), notamment une seconde tension de référence prédéfinie,
des moyens étant prévus pour éviter que dans le second mode de fonctionnement, le convertisseur analogique/numérique (ADC1, ADC2) utilise au moins une autre tension de référence,
et pour le contrôle du fonctionnement dans le second mode, on convertit un signal analogique prédéfini en un signal numérique et on exploite ce signal numérique pour vérifier le fonctionnement,
**caractérisé par**
des moyens qui interdisent par la sélection du signal analogique prédéfini, pour le contrôle de fonctionnement, comme signal d'entrée, l'utilisation de l'autre tension de référence (UREF2) par le convertisseur analogique/numérique (ADC1, ADC2) et en cas de sélection non réussie du signal analogique prédéfini comme signal d'entrée, le convertisseur analogique/numérique (ADC1, ADC2) peut utiliser l'autre tension de référence (UREF2).
